# EUROPEAN PATENT APPLICATION

(11) **EP 4 839 064 A1**
(43) Date of publication of application: **11.11.2026**
(21) Application number: 26177257.8
(22) Date of filing: 07.05.2026
(51) Int. Cl.: H10H 20/85, H10H 20/853, H10H 20/854, H10H 20/855

(54) **LIGHT EMITTING DEVICE**

(30) Priority: 09.05.2025 US 202563802639 P
(71) Applicant: Seoul Viosys Co., Ltd., Ansan-si, Gyeonggi-do 15429 (KR)
(72) Inventor: PARK, KiYon, 15429 Ansan-si, Gyeonggi-do (KR); KIM, MyungJin, 15429 Ansan-si, Gyeonggi-do (KR)
(74) Representative: Stolmár & Partner Patentanwälte PartG mbB

(57) **Abstract**

A light emitting device includes: a substrate; a light emitting element supported on the substrate to generate light; a partition supported on the substrate and providing an accommodation space accommodating the light emitting element; a transmitting layer supported on the partition to cover the accommodation space; and a fluidic optical layer disposed in the accommodation space to cover the light emitting element. The fluidic optical layer is hydrophobic.

## Description

### TECHNICAL FIELD

The present disclosure relates to a light emitting device.

### BACKGROUND OF THE INVENTION

A light emitting diode is a semiconductor device emitting light generated by recombination of electrons and holes, and is recently used in various fields such as displays, vehicle lamps, and general lighting. Since the light emitting diode has a long lifespan, low power consumption, and a fast response speed, the light emitting diode is applied to various fields such as vehicle lamps and display devices.

Recently, since light emitting diodes may be applied to various fields including display devices, lighting devices, vehicle lamps, ships, and the like, there is a need for the reliability and light efficiency of the light emitting diodes to be further increased.

### SUMMARY OF THE INVENTION

Example embodiments of the present disclosure have been conceived in view of the above-described background, and are directed to providing a light emitting device with improved reliability and luminous efficiency.

In addition, the present disclosure is directed to providing a light emitting device capable of preventing moisture, foreign substances, and the like from penetrating into a light-emitting element of the device.

In accordance with a first embodiment of the present disclosure, there is provided a light emitting device including: a substrate; a light emitting element supported on the substrate to generate light; a partition supported on the substrate and providing an accommodation space accommodating the light emitting element; a transmitting layer supported on the partition to cover the accommodation space; and a fluidic optical layer disposed in the accommodation space to cover the light emitting element, wherein the fluidic optical layer is hydrophobic.

Further, an upper end of the fluidic optical layer may contact the transmitting layer, and a lower end of the fluidic optical layer may contact the substrate.

Further, the fluidic optical layer may be spaced apart from the partition.

Further, the fluidic optical layer may be a liquid.

Further, the fluidic optical layer may include a fluororesin oil or a silicone oil.

Further, an air layer may be formed between the partition and the fluidic optical layer.

Further, in a plan view, an area of the air layer may be greater than an area of the fluidic optical layer.

Further, a minimum width portion having a width smaller than a width of an upper end of the fluidic optical layer and a width of a lower end of the fluidic optical layer may be formed between the upper end and the lower end of the fluidic optical layer.

Further, the minimum width portion may be positioned lower than the center of the light emitting element.

Further, the fluidic optical layer may include: a first optical region contacting the substrate and positioned below the minimum width portion; and a second optical region positioned above the minimum width portion to cover a side surface and an upper surface of the light emitting element.

Further, a width of the second optical region may increase upward, and a width of the first optical region may increase downward.

Further, the second optical region and the first optical region may be spaced apart from the partition, and a separation distance between an upper end of the second optical region and the partition may be greater than a separation distance between an edge of a region directly above the light emitting element and an edge of the second optical region.

Further, a length of the first optical region in a vertical direction may be smaller than a length of the second optical region in the vertical direction.

Further, a separation distance between the light emitting element and the transmitting layer may be greater than a length of the first optical region in a vertical direction.

Further, the fluidic optical layer may be spaced apart from the partition and cover a circumferential surface and an upper surface of the light emitting element, and a fluidity of the fluidic optical layer may be greater than a fluidity of the transmitting layer.

One embodiment of the present disclosure has the advantage that reliability and luminous efficiency can be improved.

In addition, one embodiment of the present disclosure has the advantage of preventing moisture, foreign substances, and the like from penetrating into the light emitting element.

### BRIEF DESCRIPTION OF THE DRAWINGS

FIG. 1 is a view illustrating a state when a light emitting device according to an embodiment of the present disclosure is a sterilizing device.
FIG. 2 is a view illustrating the light emitting device according to the embodiment of the present disclosure.
FIG. 3 is a cross-sectional view cutting the light emitting device of FIG. 2 along A-A'.
FIG. 4 is a view illustrating a transmitting layer of a light emitting device according to the embodiment of the present disclosure including a curved surface.

### DETAILED DESCRIPTION OF THE INVENTION

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, a light emitting device 1 according to an embodiment of the present disclosure will be described.

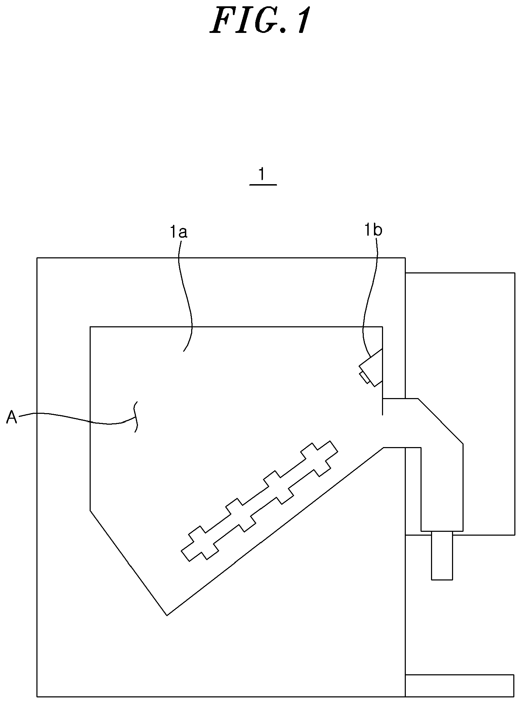

Referring to FIG. 1, a light emitting device 1 according to the embodiment of the present disclosure may be a sterilizing device. The sterilizing device may be a device for sterilizing bacteria, foreign substances, and the like. Such a sterilizing device may be a fluid sterilizing device such as a water purifier, a refrigerator, an ice maker, and an air purifier, but is not limited thereto. Such a sterilizing device may provide an accommodation space A for accommodating water or ice. Furthermore, the sterilizing device may sterilize water, ice, air, and the accommodation space A. The sterilizing device may include a housing assembly 1a and a sterilizing module 1b.

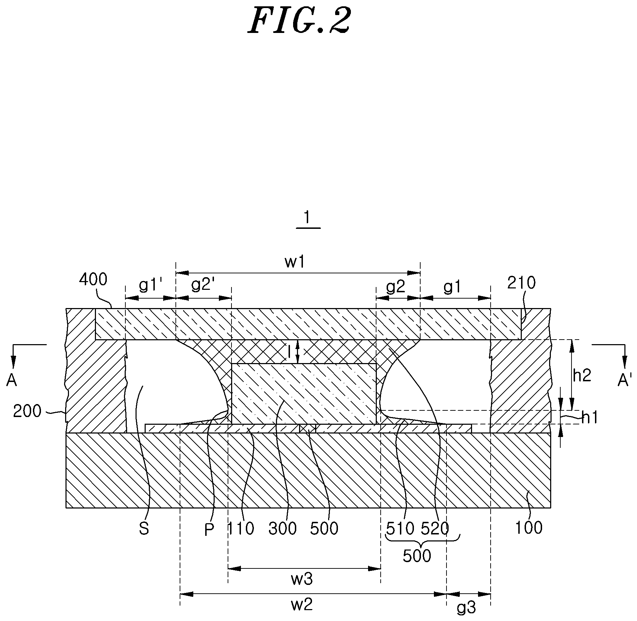

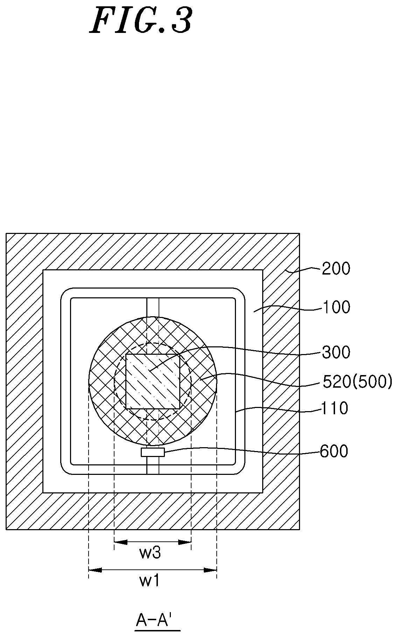

Referring to FIG. 2 and FIG. 3, the light emitting device 1 may include a substrate 100, a partition 200, a light emitting element 300, a transmitting layer 400, a fluidic optical layer 500, and a protection element 600. The substrate 100, the partition 200, the light emitting element 300, the transmitting layer 400, the fluidic optical layer 500, and the protection element 600 may be included in the sterilizing module 1b.

The partition 200, the light emitting element 300, and the fluidic optical layer 500 may be disposed on the substrate 100. For example, the substrate 100 may be a printed circuit board (PCB) substrate on which an electric circuit is printed. The substrate 100 may include an alloy composed of a part or at least one of Cu, Zn, Au, Ni, Al, Mg, Cd, Be, W, Mo, Si, Ag, and Fe having thermal conductivity, and through this, thermal and electrical conductivity may be increased. However, this is an example and the substrate 100 may include one or more of insulating materials such as FR1, CEM-1, FR-4, PMMA, PCT, and PPA, thereby preventing a short circuit between respective circuits. Here, FR1 is a material formed by laminating copper foil and laminate paper, and CEM-1 is a material formed by sequentially laminating copper foil, glass fiber fabric, laminate paper, and glass fiber fabric. Furthermore, FR-4 is a material formed by laminating copper foil and glass fiber fabric or glass fiber cloth. In addition, the substrate 100 may include a ceramic such as alumina (Al₂O₃), aluminum nitride (AlN), or ZTA (zirconia toughened alumina). A substrate electrode 110 may be formed on one surface of such a substrate 100. The substrate electrode 110 may be disposed on one surface of the substrate 100 to be electrically connected to the light emitting element 300. Such a substrate electrode 110 may be a circuit line of the substrate 100. Furthermore, the substrate electrode 110 may include a reflective material for reflecting light generated from the light emitting element 300. The reflective material may include Ag, Al, Au, Ni, or the like. The reflective material may be formed of a plurality of layers.

The partition 200 may be disposed on the substrate 100 to provide an accommodation space accommodating the light emitting element 300. For example, the partition 200 may extend upward from an edge of the substrate 100. A height of the partition 200 may be higher than a height of the light emitting element 300. The partition 200 may reflect light generated from the light emitting element 300. Furthermore, a partition groove 210 may be formed in the partition 200. An edge of the transmitting layer 400 may be inserted and supported in the partition groove 210. One region of the transmitting layer 400 may be disposed above the partition groove 210. An adhesive having fluidity may be disposed between the partition groove 210 and the transmitting layer 400, preventing the transmitting layer 400 from being damaged by temperature stress. The partition groove 210 may be recessed downward from an upper surface of the partition 200, extending along an inner circumferential surface of the partition 200. One side surface of the partition 200 may have regions having different widths. One side surface of the partition 200 may have roughness.

The light emitting element 300 may be disposed on the substrate 100 to generate light. For example, the light emitting element 300 may generate blue, green, red, white light, UV light, or the like. The light emitting element 300 may be electrically connected to the substrate electrode 110 of the substrate 100 and receive electricity from the outside through an electric circuit to generate light. Such a light emitting element 300 may include a first conductive semiconductor layer, an active layer, and a second conductive semiconductor layer.

The first conductive semiconductor layer is a semiconductor layer having a polarity opposite to a polarity of the second conductive semiconductor layer. The first conductive semiconductor layer may include an n-type impurity (e.g., Si, Ge, Sn). The first conductive semiconductor layer may be an n-type semiconductor layer. However, this is an example and the first conductive semiconductor layer may include a p-type impurity.

The active layer may be laminated on the first conductive semiconductor layer. In other words, the active layer may be positioned between the first conductive semiconductor layer and the second conductive semiconductor layer. Furthermore, the active layer may be disposed to be offset toward one side from a center of the light emitting element 300 in a thickness direction. By such an active layer, a length of the first conductive semiconductor layer in a thickness direction may be formed to be greater than a length of the second conductive semiconductor layer in the thickness direction.

The second conductive semiconductor layer may be laminated on the active layer. The second conductive semiconductor layer may include a p-type impurity (e.g., Mg, Sr, Ba), and in this case, the second conductive semiconductor layer may be a p-type semiconductor layer. However, this is an example and the second conductive semiconductor layer may include an n-type impurity. Light generated in the active layer may pass through the second conductive semiconductor layer to be emitted to the outside.

The transmitting layer 400 may be supported by the partition 200 to cover the accommodation space of the partition 200. In other words, the transmitting layer 400 may be supported by an edge of the partition 200 to cover the light emitting element 300. The transmitting layer 400 may be disposed to be spaced apart upward from the light emitting element 300. Light generated from the light emitting element 300 may pass through such a transmitting layer 400. For example, the transmitting layer 400 may be glass. Furthermore, the transmitting layer 400 may include quartz, borosilicate glass, soda-lime glass, silicone resin, epoxy resin, PPA, or the like. The transmitting layer 400 may protect the light emitting element 300 from external moisture or dust to increase reliability. The transmitting layer 400 may be an optical component for refracting or reflecting an optical path to form an image or control light.

The fluidic optical layer 500 may be disposed in the accommodation space of the partition 200 to cover the light emitting element 300. The fluidic optical layer 500 may be disposed to surround a circumferential surface and an upper surface of the light emitting element 300. In a plan view of the fluidic optical layer 500, an edge of the light emitting element 300 may be disposed inside an edge of the fluidic optical layer 500. Such a fluidic optical layer 500 may be hydrophobic. The fluidic optical layer 500 may have a hydrophobic molecular structure having low affinity with water, lowering interfacial energy with moisture to suppress moisture penetration. Such a hydrophobic property may lower water vapor permeability, reducing deterioration of characteristics of the light emitting element 300 due to moisture. The fluidic optical layer 500 may be a gel having higher fluidity than the transmitting layer 400 or may be a liquid. Through such fluidity, damage to the fluidic optical layer 500 due to heat in an element having high thermal resistance, such as a thermal shock or a UV light emitting element, may be reduced, and reliability may be improved. The fluidic optical layer 500 may have a lower viscosity than the transmitting layer 400. For example, the fluidic optical layer 500 may be an optical oil having a low viscosity. Silicone oil may be used as the optical oil, and generally has a refractive index of 1.4 to 1.55. Types of silicone oil may include low viscosity PDMS oil, high-polymer PDMS oil, phenyl-substituted silicone oil, and the like. Without being limited thereto, a fluororesin oil may also be used. The refractive index of the fluororesin oil may be in the range of 1.2 to 1.4, and representative examples thereof include perfluoropolyether (PFPE) and HFE-based fluids. These oils may be utilized to adjust a beam angle of a light emitting element by refracting light, and generally, since the refractive index is lower than that of glass or sapphire, the beam angle of the light may be widened or the light may be diffused.

An upper end of the fluidic optical layer 500 may contact the transmitting layer 400. A lower end of the fluidic optical layer 500 may contact the substrate 100. The fluidic optical layer 500 may be spaced apart from the partition 200. An air layer S may be formed between the fluidic optical layer 500 and the partition 200. Through this, the fluidic optical layer 500 may perform a light guide role of adjusting a beam angle of the light emitting device 1 by inducing reflection at an interface between the fluidic optical layer 500 and the air layer S. Light generated from the light emitting element 300 may pass through the fluidic optical layer 500. For example, a UV transmittance of the fluidic optical layer 500 may be 30% to 80%, and more specifically, the transmittance in deep UV of 300 nm or less may be 30% to 70% or less.

Furthermore, a minimum width portion P having a width w3 smaller than a width w1 of the upper end and a width w2 of the lower end may be formed between the upper end and the lower end of the fluidic optical layer 500. Furthermore, the minimum width portion P may be positioned lower than a center of the light emitting element 300. Such a fluidic optical layer 500 may include a first optical region 510 and a second optical region 520.

The first optical region 510 may be a portion of the fluidic optical layer 500 disposed below the minimum width portion P. The first optical region 510 may be disposed between the minimum width portion P and the substrate 100. The first optical region 510 may contact the substrate 100. In other words, the first optical region 510 may cover at least one region of the substrate electrode 110. One region of the substrate electrode 110 may include a region in which the first optical region 510 is not disposed. Furthermore, the first optical region 510 may contact a lower side of a side surface of the light emitting element 300. The first optical region 510 may be disposed to be spaced apart from the partition 200. Through this, by inducing reflection at an interface of the first optical region 510, light directed toward the partition 200 may be reduced and light efficiency may be increased. A length h1 of the first optical region 510 in the vertical direction may be smaller than a length h2 of the second optical region 520 in the vertical direction. Through this, an optical path may be guided to an upper surface of the light emitting device 1, increasing light extraction efficiency. A width of the first optical region 510 may increase downward. Through this, structural stability may be increased. Furthermore, the length h1 of the first optical region 510 in the vertical direction may be smaller than a separation distance 1 between the light emitting element 300 and the transmitting layer 400. Through this, the optical path may be guided to the upper surface, increasing light extraction efficiency.

The second optical region 520 may be a portion of the fluidic optical layer 500 disposed above the minimum width portion P. The minimum width portion P may be a point or region formed to have the smallest width in the fluidic optical layer 500. The second optical region 520 may be disposed between the minimum width portion P and the transmitting layer 400. The second optical region 520 may extend upward from the first optical region 510 to cover a side surface and an upper side of the light emitting element 300. The second optical region 520 may guide the optical path to the upper surface, increasing light extraction efficiency. In other words, the second optical region 520 may surround the circumferential surface and the upper surface of the light emitting element 300. The second optical region 520 may protect the side surface of the light emitting element 300 from an external environment such as moisture, improving high-humidity reliability. The second optical region 520 may be disposed to be spaced apart from the partition 200. Furthermore, a separation distance between at least a portion of the second optical region 520 and the partition 200 may decrease upward. In other words, a width of the second optical region 520 may increase upward. A shape of such a second optical region 520 may induce reflection at an interface of the second optical region 520, reducing light directed toward the partition 200 and increasing light efficiency. Furthermore, the second optical region 520 may have a concave shape toward a central region of the transmitting layer 400. Such a second optical region 520 may guide the optical path to the upper surface, increasing light extraction efficiency.

A separation distance g1 between an upper end of the second optical region 520 and the partition 200 may be formed to be greater than a separation distance g2 between an edge of a region directly above the light emitting element 300 and an edge of the second optical region 520. Through this, light directed toward the partition 200 may be reduced and light efficiency may be increased. Furthermore, the separation distance g1 between the second optical region 520 and the partition 200 and a separation distance g3 between the first optical region 510 and the partition 200 may be different. For example, the separation distance g1 between the second optical region 520 and the partition 200 may be smaller than the separation distance g3 between the first optical region 510 and the partition 200. Through this, the optical path may be guided to the upper surface, increasing light extraction efficiency.

Meanwhile, to resolve non-uniformity of a light emission pattern of the light emitting element 300, the separation distance g1 between the second optical region 520 and the partition 200 may be formed asymmetrically with respect to the light emitting element 300. In other words, a first shortest separation distance g1 between one side of the second optical region 520 and the partition 200 and a second shortest separation distance g1' between the other side opposite to the one side of the second optical region 520 and the partition 200 may be formed differently from each other. Furthermore, a first longest separation distance g2 between one side of the region directly above and the partition 200 and a second longest separation distance g2' between the other side of the region directly above and the partition 200 may be formed differently from each other.

The fluidic optical layer 500 may also be disposed below the light emitting element 300. The fluidic optical layer 500 may be disposed between the substrate electrodes 110. Through this, moisture penetrating through a lower surface of the light emitting element 300 may be reduced. At this time, the fluidic optical layer 500 may fill the entire region between the substrate electrodes 110. Through this, stability may be increased. However, the present disclosure is not limited thereto, and the fluidic optical layer 500 may be formed thinly along a surface of the substrate electrode 110.

Referring to FIG. 2, the fluidic optical layer 500 may have a curved shape. A shape of the fluidic optical layer 500 may be determined according to a shape of the light emitting element 300. For example, when the light emitting element 300 is a quadrangle having two sides with similar lengths, the shape of the fluidic optical layer 500 may be circular in a plan view. In another example, when the light emitting element 300 is a rectangle with two sides having different lengths, the shape of the fluidic optical layer 500 may be a superellipse in a plan view. In other words, in a plan view, a first cover region positioned to cover a short side of the light emitting element 300 among the fluidic optical layer 500 may have a curvature close to a circle. Furthermore, in a plan view, a second cover region positioned to cover a long side of the light emitting element 300 among the fluidic optical layer 500 may have a shape with a smaller curvature than the curvature of the first cover region. Such a fluidic optical layer 500 may sufficiently surround the light emitting element 300, preventing moisture penetration and increasing light efficiency.

Meanwhile, a radius of curvature of the first optical region 510 of the fluidic optical layer 500 may be greater than a radius of curvature of the second optical region 520. Through this, the optical path may be guided upward, increasing light extraction efficiency.

In a plan view, an inner corner region of the partition 200 may have a curved surface. A radius of curvature of the corner region may be smaller than the radius of curvature of the fluidic optical layer 500. By such shapes of the fluidic optical layer 500 and the partition 200, a gap between the fluidic optical layer 500 and the partition 200 may be sufficiently secured, reducing light loss.

The protection element 600 may protect the light emitting device 1 from impacts such as electrostatic discharge (ESD) or surges. The protection element 600 may be disposed at a distance spaced apart from the light emitting element 300. Through this, light loss due to the protection element 600 may be reduced. Furthermore, the protection element 600 may be spaced apart from the fluidic optical layer 500. The protection element 600 may be disposed on the substrate 100 to be disposed outside a region in which the fluidic optical layer 500 is disposed. Since the protection element 600 may be disposed outside the fluidic optical layer 500, an influence on the optical path may be reduced, and light extraction efficiency may be increased. A length of a cross section of the fluidic optical layer 500 in one direction may be longer than a length of a minor axis of the protection element 600. The one direction of the cross section of the fluidic optical layer 500 may be the same direction as an extending direction of the minor axis of the protection element 600. The length of the minor axis of the protection element 600 may be smaller than the separation distance g3 between the first optical region 510 of the fluidic optical layer 500 and the partition 200. Through this, a design difficulty for spacing the protection element 600 apart from the first optical region 510 may be lowered.

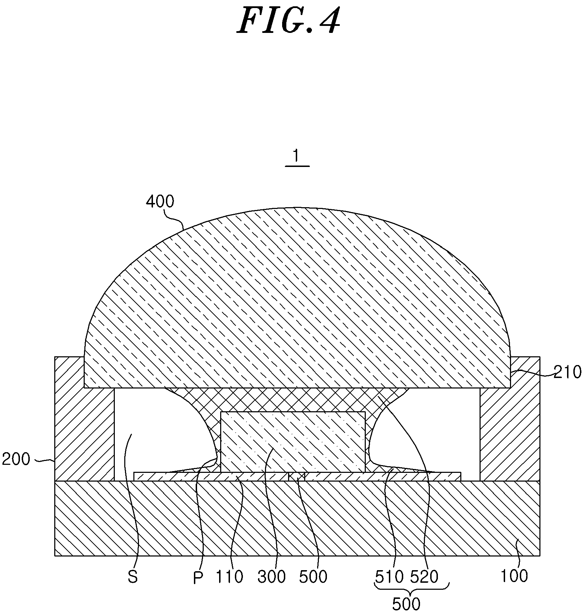

Meanwhile, further referring to FIG. 4, the light emitting device 1 may include a transmitting layer 400 having a curved surface. A maximum height of the transmitting layer 400 may be higher than an entire height of the fluidic optical layer 500. A length of the transmitting layer 400 in a lateral direction may be longer than a maximum length of the fluidic optical layer 500 in the lateral direction. A radius of curvature of the transmitting layer 400 may be greater than a maximum radius of curvature of the fluidic optical layer 500.

Hereinafter, actions and effects of the light emitting device 1 according to the embodiment of the present disclosure will be described.

Light generated from the light emitting element 300 of the light emitting device 1 of the present disclosure may sequentially pass through the fluidic optical layer 500 and the transmitting layer 400.

Since such a fluidic optical layer 500 may cover the light emitting element 300, the fluidic optical layer 500 may prevent moisture, foreign substances, or the like introduced between the partition 200 and the transmitting layer 400 from penetrating into the light emitting element 300.

Furthermore, the fluidic optical layer 500 may increase an amount of light of the light emitting device 1.

The examples of the present disclosure have been described above as specific embodiments, but these are only examples, and the present disclosure is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present disclosure. In addition, those skilled in the art can easily change or modify the disclosed embodiments based on the present specification, and it is clear that such changes or modifications also belong to the scope of the present disclosure.

## Claims

1. A light emitting device comprising:
a substrate;
a light emitting element supported on the substrate to generate light;
a partition supported on the substrate and providing an accommodation space accommodating the light emitting element;
a transmitting layer supported on the partition to cover the accommodation space; and
a fluidic optical layer disposed in the accommodation space to cover the light emitting element,
wherein the fluidic optical layer is hydrophobic.

2. The light emitting device of claim 1, wherein an upper end of the fluidic optical layer contacts the transmitting layer, and a lower end of the fluidic optical layer contacts the substrate.

3. The light emitting device of claim 1, wherein the fluidic optical layer is spaced apart from the partition.

4. The light emitting device of claim 1, wherein the fluidic optical layer is a liquid.

5. The light emitting device of claim 4, wherein the fluidic optical layer includes a fluororesin oil or a silicone oil.

6. The light emitting device of claim 1, wherein an air layer is formed between the partition and the fluidic optical layer.

7. The light emitting device of claim 6, wherein in a plan view, an area of the air layer is greater than an area of the fluidic optical layer.

8. The light emitting device of claim 1, wherein a minimum width portion having a width smaller than a width of an upper end of the fluidic optical layer and a width of a lower end of the fluidic optical layer is formed between the upper end and the lower end of the fluidic optical layer.

9. The light emitting device of claim 8, wherein the minimum width portion is positioned lower than the center of the light emitting element.

10. The light emitting device of claim 9, wherein the fluidic optical layer comprises:
a first optical region contacting the substrate and positioned below the minimum width portion; and
a second optical region positioned above the minimum width portion to cover a side surface and an upper surface of the light emitting element.

11. The light emitting device of claim 10, wherein a width of the second optical region increases upward, and a width of the first optical region increases downward.

12. The light emitting device of claim 10, wherein the second optical region and the first optical region are spaced apart from the partition, and a separation distance between an upper end of the second optical region and the partition is greater than a separation distance between an edge of a region directly above the light emitting element and an edge of the second optical region.

13. The light emitting device of claim 10, wherein a length of the first optical region in a vertical direction is smaller than a length of the second optical region in the vertical direction.

14. The light emitting device of claim 10, wherein a separation distance between the light emitting element and the transmitting layer is greater than a length of the first optical region in a vertical direction.

15. The light emitting device of claim 1, wherein the fluidic optical layer is spaced apart from the partition and covers a circumferential surface and an upper surface of the light emitting element, and
wherein a fluidity of the fluidic optical layer is greater than a fluidity of the transmitting layer.
